(19) **Europäisches Patentamt / European Patent Office / Office européen des brevets**

(11) **EP 2 957 018 B1**

(12) **FASCICULE DE BREVET EUROPEEN**

(45) Date de publication et mention de la délivrance du brevet:
**01.02.2017 Bulletin 2017/05**

(21) Numéro de dépôt: **14709994.9**

(22) Date de dépôt: **13.02.2014**

(51) Int Cl.:
*B60L 11/18* (2006.01)     *H01M 10/0525* (2010.01)
*H01M 10/44* (2006.01)     *H02J 7/00* (2006.01)
*G01R 31/36* (2006.01)

(86) Numéro de dépôt international:
**PCT/FR2014/050277**

(87) Numéro de publication internationale:
**WO 2014/125215 (21.08.2014 Gazette 2014/34)**

(54) **GESTION DE LA CHARGE D'UNE BATTERIE**

VERWALTUNG DER AUFLADUNG EINER BATTERIE

MANAGING THE CHARGING OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.02.2013 FR 1351264**

(43) Date de publication de la demande:
**23.12.2015 Bulletin 2015/52**

(73) Titulaire: **Renault S.A.S.**
**92100 Boulogne-Billancourt (FR)**

(72) Inventeurs:
- **SAINT-MARCOUX, Antoine**
  **F-91120 Palaiseau (FR)**
- **ORIGUCHI, Masato**
  **F-78120 Rambouillet (FR)**
- **DRIEMEYER-FRANCO, Ana-Lucia**
  **F-78180 Montigny-le-Bretonneux (FR)**
- **BOIRON, Daniel**
  **F-78960 Voisins-le-Bretonneux (FR)**

(56) Documents cités:
**WO-A2-02/41466          CA-A1- 2 792 810**
**US-A1- 2009 140 700**

EP 2 957 018 B1

**Description**

L'invention concerne le domaine de la gestion de la charge d'une batterie. L'invention peut trouver un exemple d'application dans l'industrie automobile, notamment pour la gestion de la charge d'une batterie de traction de véhicule électrique et/ou hybride. Ce type de batteries, notamment de type Lihtium-ion, comporte une pluralité d'accumulateurs électriques, ou cellules, incluant un système électrochimique rechargeable destiné à fournir une tension nominale. Elles sont généralement contrôlées par un système de contrôle de batterie (BMS - « Battery Management System ») qui est un système électronique de contrôle de l'état des différents éléments ou paramètres d'une batterie au lithium, et notamment de ses cellules constitutives comportant une électrode négative et une électrode positive.

Un système BMS est un élément important sur toutes les batteries au lithium ou les ensembles de batteries comprenant une batterie et un système BMS. Il surveille l'état de différents éléments ou paramètres de la batterie, tels que la tension totale ou des cellules individuelles, la température : température moyenne, température d'admission de liquide de refroidissement, température de sortie de liquide de refroidissement, ou températures des cellules individuelles et l'état de charge ou la profondeur de décharge. Un système BMS permet le suivi de données, telles que la puissance de charge et la puissance de décharge maximales, l'énergie fournie depuis la dernière charge ou le dernier cycle de charge, l'énergie totale utilisée depuis la première utilisation et le temps total de fonctionnement depuis la première utilisation.

Un système BMS assure une protection de la batterie en l'empêchant de fonctionner en dehors de sa plage de fonctionnement typique, et assure une protection notamment contre la sur-intensité, la sur-tension (lors de la charge), la sous-tension (lors de la décharge) ou encore, ce qui est particulièrement important pour les batteries Li-ion, contre la surchauffe et la sous-température.

En particulier, le système BMS permet de gérer la charge de la batterie en indiquant à chaque instant quel est le niveau maximal de puissance autorisée en charge et si la batterie est pleinement chargée ou non.

A cet effet, un des paramètres prépondérants pris en compte est la tension de fin de charge ou tension de coupure, qui peut, par exemple, être mesurée aux bornes de la batterie. En effet, cette tension est représentative de la limite de charge des cellules constitutives de la batterie. Autrement dit, c'est la valeur que doit atteindre la tension maximale de chaque cellule en fin de charge pour juger que la charge est bien terminée. Dans la technologie batterie Li-ion, la tension de coupure peut être comprise entre 2,5 V et 4,5 V, de préférence entre 3,5 V et 4,2 V. Hormis le choix de la tension de fin de charge, la définition d'une stratégie de charge revêt une importance capitale, car elle permet de rechercher un compromis entre durabilité de la batterie et le temps de charge. Pour une même tension de fin de charge donnée, lorsqu'on limite fortement la puissance autorisée en charge, on améliore la durabilité au détriment du temps de charge, et lorsqu'on autorise une forte puissance en charge, on diminue le temps de charge, au détriment de la durabilité.

Une des difficultés réside dans le fait que pour une tension de fin de charge (tension de coupure) prédéterminée, l'énergie disponible pour un utilisateur n'est pas la même, en lien principalement avec trois facteurs :

- la température de la batterie. Ainsi, plus la température de la batterie est basse, plus l'énergie qui peut être déchargée à partir de cette tension de coupure est faible, car les résistances internes des cellules sont plus importantes ;
- le vieillissement de la batterie. Plus la batterie est dégradée (« faible état de santé »), plus l'énergie qui peut être déchargée à partir de cette tension de coupure est faible, car la capacité disponible (en A.h) dans la batterie est limitée. L'état de vieillissement de la batterie est défini comme étant le rapport entre la capacité disponible dans la batterie entre un état de charge nul et un état de charge maximum à un instant *t*, et la capacité disponible dans la batterie entre un état de charge nul et un état de charge maximum en début de vie. Ainsi, le rapport est de 100% au début d'utilisation de celle-ci.
- le déséquilibre cellule, défini comme étant la différence entre l'état de charge de la cellule présentant la charge la plus haute et l'état de charge de la cellule présentant la charge la plus basse. Ainsi, plus le déséquilibre cellule est important, plus l'énergie qui peut être déchargée à partir de cette tension de coupure est faible, parce que la cellule la plus basse va atteindre sa tension limite de fin de décharge (niveau de charge minimal) beaucoup plus tôt que les autres cellules.

Ces facteurs concourent dans le sens d'une augmentation de la tension de fin de charge, pour permettre d'assurer à un utilisateur un niveau d'énergie suffisant.

A l'inverse, plus la tension de fin de charge est élevée, plus on utilise la batterie dans une plage de fonctionnement où elle se dégradera rapidement. On dispose certes de plus d'énergie en début de vie, mais au bout de quelques mois ou années, le vieillissement de la batterie se sera accentué de manière inacceptable pour l'utilisateur, et une augmentation de la tension de fin de charge ne sera pas suffisante pour compenser la perte de capacité.

En termes de prestations, la batterie, comportant les cellules et le système BMS, doit assurer un niveau d'énergie minimal requis, non seulement en début de vie, mais également après un certain nombre d'années.

EP 2 957 018 B1

Un problème à résoudre relatif au système BMS est la définition d'une stratégie de fin de charge qui permette (i) en début de vie, d'assurer un niveau d'énergie minimal requis malgré un déséquilibre cellule en sortie d'usine (ou chaînes de fabrication) plus important que prévu du fait du process de fabrication (ii) sur les première années d'utilisation du véhicule, de compenser totalement la perte d'énergie dans la batterie.

Afin d'assurer pour un utilisateur un niveau d'énergie disponible égal ou légèrement supérieur au niveau d'énergie minimal requis, une solution admise consiste à choisir une tension de fin de charge qui soit fixée et déterminée, dans les conditions suivantes : une température de référence fixée, par exemple à 25°C, un niveau de vieillissement de la batterie donné, par exemple en début de vie, un niveau de déséquilibre nominal, par exemple moins de 3% de déséquilibre entre la cellule la plus chargée et la cellule la moins chargée.

En revanche, dans les autres cas que ceux indiqués ci-dessus, l'énergie effectivement disponible pour l'utilisateur est plus faible que ce qui est attendu.

A l'inverse, si le déséquilibre cellule est sensiblement plus faible que le déséquilibre nominal, ce qui peut également se produire en sortie d'usine, alors il y aura plus d'énergie de disponible dans la batterie que ce qui est strictement nécessaire. Ceci n'est pas souhaitable, car cela revient à utiliser la batterie sur une plage d'utilisation plus importante que ce qui est nécessaire, ce qui se traduit en termes de perte de capacité au bout de plusieurs années d'utilisation.

De nombreux brevets décrivent explicitement le principe de la charge CC-CV - Charge à courant constant (CC) d'abord, suivie d'une charge en régulant par rapport à une tension de référence (CV), tel que le document WO2012 074406 A2, et qui permet de choisir des algorithmes de charge différents dans le système BMS, en fonction des conditions, telles que la température, le réseau électrique (prix du courant) et du type de chargeur proprement dit. Cette logique permet de charger la batterie jusqu'à un niveau d'énergie souhaité dans des conditions nominales. Mais, seule, elle ne permet pas de gérer toutes les causes de « dispersion », telles que le déséquilibre cellule, la température de la batterie, et le vieillissement de la batterie.

L'invention vise à résoudre au moins l'un des inconvénients ci-dessus. En particulier, un but de l'invention est de proposer un procédé de gestion de charge permettant d'assurer un niveau d'énergie minimal requis, tout en limitant la dégradation de la batterie.

On identifiera enfin le document US 2009/140700 A1 du 4 juin 2009 qui décrit un procédé de gestion de charge d'une batterie Li-ion en fonction du vieillissement de la batterie, comprenant les étapes suivantes de : a) détermination de la valeur de tension de fin de charge de ladite batterie, b) Génération d'un signal de commande de charge de ladite batterie et de transmission du signal de commande vers un chargeur.

L'invention concerne donc un procédé de gestion de charge d'une batterie Li-ion en fonction d'au moins un paramètre choisi dans le groupe constitué par le vieillissement de la batterie et le déséquilibre cellule représentant la différence entre l'état de charge de la cellule présentant la charge la plus haute et l'état de charge de la cellule présentant la charge la plus basse, comprenant les étapes suivantes de :

a) détermination d'une valeur de tension de fin de charge de ladite batterie,
b) Génération d'un signal de commande de charge de ladite batterie et de transmission du signal de commande vers un chargeur, le signal de commande étant généré de sorte que la charge de la batterie est effectuée en fonction de la valeur de la tension de fin de charge déterminée à l'étape a), ladite valeur tension de fin de charge étant augmentée en fonction de l'état de vieillissement croissant de ladite batterie Li-ion jusqu'à une valeur limite pour assurer un niveau d'énergie minimal requis, constant, dans ladite batterie Li-ion, pour une température de référence prédéterminée.

Selon l'invention, il est donc possible de mettre à disposition de l'utilisateur une batterie Li-ion présentant un niveau d'énergie minimal requis, par exemple compris entre 18 kWh et 22 kWh, étant en outre constant, pour une température de référence donnée, par exemple 25°C, typiquement dans la plage 15°C - 40°C et ce avantageusement pour une période d'utilisation la plus longue permise, tout en évitant d'utiliser la batterie sur une plage de tension trop large impliquant sa dégradation prématurée. Il est ainsi possible de prendre en compte le vieillissement de la batterie et/ou le déséquilibre cellule pour moduler la tension de fin de charge afin d'assurer le niveau d'énergie minimal requis de la batterie.

Plus la batterie est dégradée (« faible état de santé »), plus l'énergie qui peut être déchargée à partir de cette tension de coupure est faible, car la capacité disponible (en A.h) dans la batterie est limitée, et c'est la raison pour laquelle la tension de coupure doit être augmentée et fixée pour la charge.

A titre d'exemple, en début de vie de la batterie ou, dit autrement, pour un vieillissement nul ou encore un état de santé de 100%, la tension de coupure peut prendre une valeur égale à 4,08 V pour chacune des cellules constitutives de la batterie, cette valeur pouvant être augmentée et fixée par exemple à 4,11 V lorsque l'état de santé de la batterie est d'environ 88%, et par exemple fixée à 4.13 V lorsque l'état de santé de la batterie est compris entre 80% et 65%.

Le procédé de l'invention peut être avantageusement mis en oeuvre par un système de contrôle de batterie BMS, lequel comporte un programme d'ordinateur comprenant des instructions pour déterminer la valeur de tension de charge de ladite batterie (étape a)) et décider de procéder à une augmentation de cette valeur en fonction de l'état de vieillissement croissant de la batterie.

Dans le cadre de l'invention, on entend par « signal » aussi bien un signal électrique, différentiel, analogique ou d'une autre nature, tel qu'un signal électromagnétique.

L'étape a) peut avantageusement comprendre une étape de génération d'un signal de détermination de la valeur de tension de fin de charge de ladite batterie, ledit signal permettant d'effectuer la détermination de la valeur de tension de fin de charge.

Le procédé peut avantageusement comprendre, préalablement à l'étape a), une étape de génération et de traitement d'un signal d'évaluation de l'état de vieillissement de la batterie.

Cette étape peut être mise en oeuvre par plusieurs méthodes connues de l'homme du métier. Il peut s'agir d'une caractérisation de la résistance interne de la batterie ou d'une estimation de la capacité totale disponible dans la batterie. Un exemple d'une méthode est décrit dans WO 2007/004817A1.

De préférence, le procédé peut comprendre, après l'étape b), une étape de génération et de traitement d'un signal de fin de charge lorsque la valeur de la tension cellule maximale $\left( V_{cell}^{\max} = \max\left( V_{cell}^{i}, i \in 1..N \right) \right)$ est supérieure ou égale à la valeur de tension de fin de charge $\left( V_{EndOfCh\arg e}^{cut-Off} \right)$ et lorsque la puissance autorisée en charge dans la batterie (*PCHG*) est inférieure ou égale à la puissance maximale autorisée en fin de charge $\left( P_{EndOfCh\arg e}^{Threshold} \right)$.

La fin de charge peut typiquement être signalée par un indicateur fonctionnant selon un système booléen.

Des valeurs typiques pour la tension de fin de charge peuvent être comprises entre 4,08 et 4,15 V et pour la puissance maximale autorisée en fin de charge, ces valeurs peuvent être de 1 kW.

L'importance de cet aspect peut ne pas résider tant sur le fait que la tension de la batterie soit supérieure à un seuil, mais que ce soit le cas pour un niveau de courant faible (typiquement 2A). C'est bien l'intérêt de cette double condition sur la puissance autorisée en charge et la tension maximale cellule. En effet, l'objectif d'une stratégie de charge, c'est de s'assurer que la tension de circuit ouvert (OCV) soit bien à un niveau de tension souhaitée. Or, ce qui est mesuré, c'est la tension cellule qui peut différer de la tension de circuit ouvert pour une cellule *i* de la batterie $\left( OCV_{cell}^{i} \right)$ par la relation : $DCR_{cell}^{i} \cdot I_{Bat}$, où $DCR_{cell}^{i}$ est la résistance interne de la cellule *i* (Ohm) et $I_{Bat}$ est l'intensité du courant qui traverse la batterie (A).

Ainsi, plus la puissance autorisée en charge est faible, plus le courant $I_{Bat}$ en entrée de la batterie peut être faible, et, par conséquent, plus la tension cellule $V_{cell}^{i}$ peut avantageusement être un bon indicateur de l'$OCV_{cell}^{i}$.

En outre, la fixation d'une condition sur la tension maximale cellule, au lieu de la tension minimale cellule ou de la tension moyenne cellule, peut permettre d'assurer le contrôle de la tension de toutes les cellules, et qu'aucune d'entre elles ne dépassera ce seuil prédéfini.

Tant que le déséquilibre cellule reste inférieur au niveau de déséquilibre nominal, typiquement d'au plus 20 mV, cette tension de coupure peut avantageusement permettre d'assurer le niveau d'énergie minimal requis, constant, pour l'utilisateur. En revanche, si le déséquilibre cellule dépasse le déséquilibre nominal en fin de charge, alors, cette tension de coupure peut ne pas permettre d'assurer le niveau d'énergie minimal requis, constant, pour l'utilisateur.

Selon des modes avantageux de réalisation, le procédé peut comprendre en outre à l'étape b), une étape c) de génération et de traitement d'un signal de modulation de ladite tension de fin de charge en fonction du déséquilibre cellule.

Dans ce cas, la gestion de charge de la batterie peut inclure non seulement la stratégie indiquée ci-dessus, mais également cette gestion peut tenir compte du déséquilibre cellule.

Selon ce mode de réalisation, l'étape a) peut avantageusement consister en la détermination de la tension de coupure pour la fin de charge sur la tension cellule maximale $\left( V_{EndOfCh\arg e}^{cut-Off-MAX} \right)$ et la tension de coupure pour la fin de charge sur la tension cellule minimale $\left( V_{EndOfCh\arg e}^{cut-Off-MIN} \right)$ en fonction de l'état de vieillissement de la batterie.

Selon ce mode de réalisation, le procédé peut comprendre avantageusement, après l'étape c), une étape de réception et de traitement d'un signal de fin de charge lorsque la puissance autorisée en charge dans la batterie (*PCHG*) est inférieure ou égale à la puissance maximale autorisée en fin de charge $\left( P_{EndOfCh\arg e}^{Threshold} \right)$ et lorsque la valeur de la tension cellule maximale $\left( V_{cell}^{\max} = \max\left( V_{cell}^{i}, i \in 1..N \right) \right)$ est supérieure ou égale à la tension de coupure pour la fin de charge sur la tension cellule maximale $\left( V_{EndOfCh\arg e}^{cut-Off-MAX} \right)$ ou lorsque la valeur de la tension cellule minimale $\left( V_{cell}^{\min} = \min\left( V_{cell}^{i}, i \in 1..N \right) \right)$ est supérieure ou égale à la tension de coupure pour la fin de charge sur la tension cellule minimale $\left( V_{EndOfCharge}^{cut-Off-MIN} \right)$.

Dans la mesure où c'est la tension de cellule la plus faible qui est limitante pour assurer le niveau d'énergie minimal requis dans la batterie, il peut être nécessaire que la tension minimale cellule soit supérieure (ou égale) à un seuil prédéterminé. Néanmoins, pour assurer une durabilité optimale de la batterie, il convient habituellement d'arrêter la charge dès que la tension maximale cellule dépasse un autre seuil complémentaire, tel que défini précédemment

La puissance autorisée en charge peut être calculée de plusieurs manières connues de l'homme du métier.

A titre d'exemple non limitatif, on définit tout d'abord les variables suivantes :

$$P_{CHG}^1 = \frac{\left\{ V_{cell}^{Cut-off-MAX} - \max\left( OCV_{cell}^i, i \in 1..N \right) \right\}}{\max\left( DCR_{cell}^i, i \in 1..N \right)} \cdot V_{cell}^{Cut-off-MAX} \cdot N$$

$$P_{CHG}^2 = \frac{\left\{ V_{cell}^{Cut-off-MIN} - \min\left( OCV_{cell}^i, i \in 1..N \right) \right\}}{\max\left( DCR_{cell}^i, i \in 1..N \right)} \cdot V_{cell}^{Cut-off-MIN} \cdot N$$

Selon un premier exemple, la puissance autorisée en charge est calculée par la formule suivante :

$$PCHG = \min\left\{ P_{CHG}^1, P_{CHG}^2 \right\}$$

Selon un second exemple, on limite la puissance autorisée en charge, dès que la tension maximale cellule $V_{cell}^{\max}$ est supérieure ou égale à un seuil de tension. Ce seuil de tension peut être par exemple égal à

$$V_{\lim} = \frac{V_{cell}^{Cut-off-MIN} + V_{cell}^{Cut-off-MIN}}{2}$$

En pratique, on peut par exemple déterminer la puissance autorisée en charge par la formule suivante :

$$PCHG = \begin{cases} \min\left\{ P_{CHG}^1, P_{CHG}^2 \right\} \, si \, V_{cell}^{\max} \leq V_{\lim} \\ 0.5 \times \min\left\{ P_{CHG}^1, P_{CHG}^2 \right\} \, si \, V_{cell}^{\max} > V_{\lim} \end{cases}$$

L'intérêt des deux derniers exemples de puissance et de tensions est que celles-ci peuvent permettre de préserver la durabilité de la cellule en limitant un peu plus la puissance autorisée en charge dès que la tension cellule maximale dépasse la tension de coupure $V_{\lim}$.

Selon ce mode de réalisation, lorsque le déséquilibre cellule est inférieur au déséquilibre cellule nominal, typiquement d'au plus 20 mV, on peut assurer le niveau d'énergie minimal requis, constant, tout en diminuant la tension maximale cellule en fin de charge, c'est-à-dire que cette valeur de ladite tension peut être inférieure à la valeur de ladite tension obtenue lorsque seul le vieillissement est pris en compte.

Par ailleurs, si le déséquilibre cellule est supérieur au déséquilibre nominal, sans pour autant excéder $\left( V_{EndOfCharge}^{cut-Off-MAX} - V_{EndOfCharge}^{cut-Off-MIN} \right)$, alors on peut assurer le niveau d'énergie minimal requis, constant, dans la batterie. En particulier, cette solution permet de gérer le déséquilibre cellule qui pourrait apparaitre en sortie usine.

Dans le cas où le déséquilibre cellule excède $\left( V_{EndOfCharge}^{cut-Off-MAX} - V_{EndOfCharge}^{cut-Off-MIN} \right)$, il est de toute façon impossible d'assurer le niveau d'énergie minimale requis.

Les avantages de ce mode de réalisation sont les suivants. Il peut permettre, d'une part, d'assurer sur les premières années d'utilisation, typiquement 0-3 ans, le niveau d'énergie minimal requis, constant, pour l'utilisateur de la batterie, tant que le déséquilibre cellule reste inférieur au déséquilibre nominal et, d'autre part, de limiter en début de vie la dégradation des batteries, en limitant sa plage d'utilisation.

A titre d'exemples non limitatifs selon l'état de la technique et selon l'invention, on considère les valeurs suivantes, $V_{EndOfCharge}^{cut-Off} = 4.08V$ et le déséquilibre cellule nominal = 20 mV, pour un état de santé de la batterie de 100% (batterie neuve).

En d'autres termes, $V_{EndOfCh\arg e}^{cut-Off}$ a été fixé pour assurer 22 kWh d'énergie disponible dans la batterie, pour un déséquilibre nominal de 20 mV, c'est-à-dire : $V_{cell}^{\min} = 4.06V$. On considère également $V_{EndOfCh\arg e}^{cut-Off-MAX} = 4.10V$ et $V_{EndOfCh\arg e}^{cut-Of-MIN} = 4.06V$.

a) Si le déséquilibre cellule est tel que :$\Delta V_{cell}$ = 10$mV$, alors :

Selon l'état de la technique, la charge de la batterie est arrêtée à $V_{cell}^{\max} = 4.08V$ (et $V_{cell}^{\min} = 4.07V$). L'utilisateur aura plus de 22 kWh de disponible et la batterie aura été inutilement surchargée.

Selon l'invention, la charge de la batterie est arrêtée à $V_{cell}^{\max} = 4.07V$ (et $V_{cell}^{\min} = 4.06V$). Il y aura exactement 22 kWh de disponible, tout en limitant la tension maximale cellule.

b) Si le déséquilibre cellule est tel que :$\Delta V_{cell}$ = 40$mV$, alors :

Selon l'état de la technique, la charge de la batterie est arrêtée à $V_{cell}^{\max} = 4.08V$ (et $V_{cell}^{\min} = 4.04V$). L'utilisateur n'aura pas 22 kWh.

Selon l'invention, la charge de la batterie est arrêtée à $V_{cell}^{\max} = 4.10V$ (et $V_{cell}^{\min} = 4.06V$). Il y aura exactement 22 kWh de disponible, sans pour autant fixer une valeur trop importante de tension maximale cellule.

Dans le cadre de l'invention, la batterie Li-ion n'est nullement limitée, et peut de préférence être une batterie où le lithium reste à l'état ionique grâce à l'utilisation d'un composé d'insertion aussi bien à l'électrode négative, généralement en graphite, qu'à l'électrode positive, pouvant être en oxyde de cobalt, oxyde de manganèse ou en phosphate de fer. Parmi les batteries Li-ion, on peut citer les batteries dites « lithium métal-polymère » et « lithium-air ». Les batteries Li-ion de l'invention peuvent être applicables dans divers domaines technologique, tels que automobiles, ordinateurs ou télécoms, et peuvent être adaptés pour les systèmes embarquées ou débarqués.

Le procédé de l'invention peut être mis en oeuvre par tout type de chargeurs connus de l'homme du métier, notamment disponibles dans le commerce, et les chargeurs ne sont nullement limités.

L'invention concerne également un dispositif de gestion de charge d'une batterie Li-ion en fonction d'au moins un paramètre choisi dans le groupe constitué par le vieillissement de la batterie et le déséquilibre cellule représentant la différence entre l'état de charge de la cellule présentant la charge la plus haute et l'état de charge de la cellule présentant la charge la plus basse, comprenant,

- des moyens détermination d'une valeur de tension de fin de charge de ladite batterie,
- des moyens de traitement agencés pour générer un signal de commande de charge de ladite batterie,
- des moyens de transmission du signal de commande vers un chargeur, dans lequel les moyens de traitement sont agencés pour que le signal de commande soit généré de sorte que la charge de la batterie soit effectuée en fonction de la valeur de la tension de fin de charge déterminée, ladite valeur tension de fin de charge étant augmentée en fonction de l'état de vieillissement croissant de ladite batterie Li-ion jusqu'à une valeur limite pour assurer un niveau d'énergie minimal requis, constant, dans ladite batterie Li-ion, pour une température de référence prédéterminée.

Un tel dispositif peut en particulier être adapté à la mise en oeuvre du procédé ci-dessus avec les différentes variantes.

Les moyens de traitement peuvent comprendre un coeur de processeur ou CPU (de l'anglais « Central Processing Unit »), un processeur ou autre.

Les moyens de transmission peuvent par exemple comprendre une broche de sortie, un port de sortie ou autre. Avantageusement, le dispositif peut en outre comprendre des moyens de :

- génération d'un signal de détermination de la valeur de tension de fin de charge de ladite batterie, ledit signal permettant d'effectuer la détermination de la valeur de tension de fin de charge ;
- génération et de traitement d'un signal d'évaluation de l'état de vieillissement de la batterie,
- génération et de traitement d'un signal de fin de charge lorsque la valeur de la tension cellule maximale est supérieure ou égale à la valeur de tension de fin de charge et lorsque la puissance autorisée en charge dans la batterie est inférieure ou égale à la puissance maximale autorisée en fin de charge,
- génération et de traitement d'un signal de modulation de ladite tension de fin de charge augmentée en fonction du déséquilibre cellule.
- réception et de traitement d'un signal de fin de charge lorsque la puissance autorisée en charge dans la batterie est inférieure ou égale à la puissance maximale autorisée en fin de charge et lorsque la valeur de la tension cellule maximale est supérieure ou égale à la tension de coupure pour la fin de charge sur la tension cellule maximale ou lorsque la valeur de la tension cellule minimale est supérieure ou égale à la tension de coupure pour la fin de charge sur la tension cellule minimale.

Avantageusement, les moyens de détermination de la valeur de tension de fin de charge de ladite batterie peuvent être agencés pour déterminer la tension de coupure pour la fin de charge sur la tension cellule maximale et la tension de coupure pour la fin de charge sur la tension cellule minimale en fonction de l'état de vieillissement de la batterie.

L'invention concerne, selon un autre aspect, un programme d'ordinateur comprenant des instructions pour effectuer les étapes du procédé de l'invention, lorsque ces instructions sont exécutées par un processeur.

Avantageusement, ce programme d'ordinateur peut être stocké dans une mémoire du dispositif de gestion de gestion de charge.

L'invention concerne également un ensemble de batterie Lithium-ion comportant une batterie Lithium-ion et un dispositif de gestion de charge de la batterie, tel que décrit plus haut.

L'invention concerne également un véhicule automobile incorporant une batterie Lithium-ion et le dispositif de gestion de charge et/ou un ensemble de batterie, tels que décrits ci-dessus.

L'invention est illustrée par les figures et les exemples non limitatifs qui suivent, dans lesquels :

- la figure 1 représente un exemple de graphe illustrant la tension de fin de charge, en fonction de l'état de santé de la batterie Li-ion présentant un niveau d'énergie minimal de 22 kWh, selon un mode de réalisation,

- la figure 2 montre un exemple de graphe illustrant la tension de fin de charge, ici consistant en $\left( V_{EndOfCh\arg e}^{cut-Off-MAX} \right)$ et $\left( V_{EndOfCh\arg e}^{cut-Off-MIN} \right)$ en fonction de l'état de santé de la batterie et du déséquilibre cellule, selon un autre mode de réalisation de l'invention, et

- la Figure 3 est un exemple de véhicule automobile comprenant un ensemble de batterie de traction, selon un mode de réalisation.

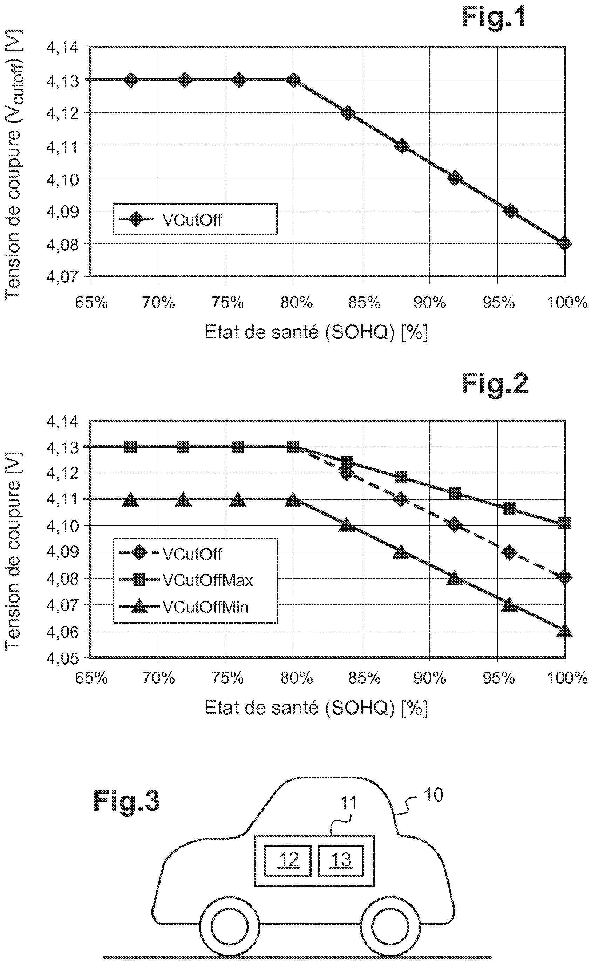

La Figure 1 représente un graphe illustrant la tension de fin de charge, en fonction de l'état de santé de la batterie Li-ion présentant un niveau d'énergie minimal de 22 kWh, selon un mode de réalisation de l'invention. Ce graphe a été établi grâce au système BMS incorporant un logiciel approprié connu.

L'état de santé (SOHQ) de la batterie a été préalablement déterminé grâce à un dispositif de calcul dans le système BMS, selon des méthodes conventionnelles connues de l'homme du métier. La tension de coupure pour un état de santé de 100% a 4,08 V pour valeur pour chacune des cellules constitutives de la batterie.

La Figure 1 indique que plus la batterie vieillit plus il convient d'augmenter la tension de fin de charge pour compenser la perte de capacité de la batterie. Dit autrement, la valeur de tension de fin de charge est augmentée en fonction de l'état de vieillissement croissant de la batterie.

La Figure 2 montre un graphe illustrant la tension de fin de charge, ici consistant en la tension de coupure pour la fin de charge sur la tension cellule maximale et la tension de coupure pour la fin de charge sur la tension cellule minimale en fonction de l'état de santé (SOHQ) de la batterie, en fonction, d'une part, de l'état de santé de la batterie Li-ion, présentant un niveau d'énergie minimal de 22 kWh, et, d'autre part, du déséquilibre cellule, selon un autre mode de réalisation de l'invention. En traits pointillés, on a reporté les valeurs de la Figure 1. Ce graphe a été établi grâce au système BMS incorporant un logiciel approprié, disponible dans le commerce.

En référence à la figure 3, un véhicule automobile 10 comprend un ensemble de batterie de traction 11, lequel peut être chargé au moyen d'un chargeur (non représenté), par exemple une borne de charge raccordée au réseau électrique.

La batterie 12 peut par exemple être une batterie lithium ion.

Le chargeur peut par exemple être une borne de charge rapide fournissant un courant continu à l'ensemble de batterie 11 du véhicule 10.

L'ensemble de batterie 11 peut intégrer un dispositif de gestion de la charge 13, par exemple un système de contrôle de batterie de type BMS, lequel comporte un programme d'ordinateur comprenant des instructions pour déterminer la valeur de tension de charge de ladite batterie et décider de procéder à une augmentation de cette valeur en fonction de l'état de vieillissement de la batterie jusqu'à une valeur limite permettant d'assurer un niveau minimal requis et constant à une température par exemple de 20°C.

Le dispositif de gestion de la charge 13 comporte des moyens de génération et de réception d'un signal de détermination de la valeur de tension de fin de charge de ladite batterie, (non représentés), par exemple une broche d'entrée en communication électrique avec des capteurs (non représentés) du véhicule automobile 10.

Le dispositif 13 comporte des moyens de traitement (non représentés) agencés pour générer un signal de commande de charge de ladite batterie et afin que le signal de commande soit généré de sorte que la charge de la batterie soit effectuée en fonction de la valeur de la tension de fin de charge déterminée à l'étape précédente, ladite valeur tension de fin de charge étant augmentée en fonction de l'état de vieillissement de ladite batterie Li-ion jusqu'à une valeur limite pour assurer un niveau d'énergie minimal requis, constant, dans ladite batterie Li-ion, pour une température de référence par exemple de 20°C.

Ces moyens de traitement sont ici un coeur d'un processeur.

Le dispositif 13 comporte des moyens de transmission du signal (non représentés) vers un chargeur, lesquels sont ici par exemple une broche de sortie.

## Exemple

Cet exemple présente la gestion de charge d'une batterie Li-ion pour assurer 22 kWh d'énergie disponible dans la batterie qui est constant pour une température de 25°C.

On considère les valeurs suivantes, $V_{EndOfCh\arg e}^{cut-Off} = 4.08V$ et le déséquilibre cellule nominal = 20 mV, l'état de santé de la batterie étant de 100% (batterie neuve).

En d'autres termes, $V_{EndOfCh\arg e}^{cut-Off}$ a été fixé pour assurer 22 kWh d'énergie disponible dans la batterie, pour un déséquilibre nominal de 20 mV, c'est-à-dire : $V_{cell}^{\min} = 4.06V$. On considère également $V_{EndOfCh\arg e}^{cut-Off-MAX} = 4.10V$ et $V_{EndOfCh\arg e}^{cut-Of-MIN} = 4.06V$.

a) Si le déséquilibre cellule est tel que : $\Delta V_{cell}$ = 10mV, alors :

Selon l'état de la technique, la charge de la batterie sera arrêtée à $V_{cell}^{\max} = 4.08V$ (et $V_{cell}^{\min} = 4.07V$). L'utilisateur aura plus de 22 kWh de disponible et la batterie aura été inutilement surchargée.

Selon l'invention, la charge de la batterie sera arrêtée à $V_{cell}^{\max} = 4.07V$ (et $V_{cell}^{\min} = 4.06V$). Il y aura exactement 22 kWh de disponible, tout en limitant la tension maximale cellule.

b) Si le déséquilibre cellule est tel que : $\Delta V_{cell}$ = 20mV, alors :

Selon l'état de la technique, la charge de la batterie sera arrêtée à $V_{cell}^{\max} = 4.08V$ (et $V_{cell}^{\min} = 4.06V$).

Selon l'invention, la charge de la batterie sera arrêtée à $V_{cell}^{\max} = 4.08V$ (et $V_{cell}^{\min} = 4.06V$).

Les deux résultats sont identiques.

c) Si le déséquilibre cellule est tel que : $\Delta V_{cell}$ = 40mV, alors :

Selon l'état de la technique, la charge de la batterie sera arrêtée à $V_{cell}^{\max} = 4.08V$ (et $V_{cell}^{\min} = 4.04V$). L'utilisateur ne bénéficiera pas l'énergie disponible de 22 kWh qui sera inférieure.

Selon l'invention" la charge de la batterie sera arrêtée à $V_{cell}^{\max} = 4.10V$ (et $V_{cell}^{\min} = 4.06V$). Il y aura exactement 22 kWh de disponible dans la batterie, sans pour autant fixer une valeur trop importante de tension maximale cellule.

d) Si le déséquilibre cellule est tel que : $\Delta V_{cell}$ = 50mV, alors :

Selon l'état de la technique, la charge de la batterie sera arrêtée à $V_{cell}^{\max} = 4.08V$ (et $V_{cell}^{\min} = 4.03V$). L'utilisateur ne bénéficiera pas l'énergie disponible de 22 kWh qui sera inférieure.

Selon l'invention, la charge de la batterie sera arrêtée à $V_{cell}^{\max} = 4.10V$ (et $V_{cell}^{\min} = 4.06V$). Il y aura un peu moins de 22 kWh d'énergie disponible dans la batterie, sans pour autant fixer une valeur trop importante de tension maximale cellule.

## Revendications

1. Procédé de gestion de charge d'une batterie Li-ion en fonction d'au moins un paramètre choisi dans le groupe constitué par le vieillissement de la batterie et le déséquilibre cellule représentant la différence entre l'état de charge de la cellule présentant la charge la plus haute et l'état de charge de la cellule présentant la charge la plus basse, comprenant les étapes suivantes de :

a) détermination d'une valeur de tension de fin de charge de ladite batterie,

b) génération d'un signal de commande de charge de ladite batterie et de transmission du signal de commande vers un chargeur, le signal de commande étant généré de sorte que la charge de la batterie est effectuée en fonction de la valeur de la tension de fin de charge déterminée à l'étape a), ladite valeur de tension de fin de charge étant augmentée en fonction de l'état de vieillissement croissant de ladite batterie Li-ion jusqu'à une valeur limite pour assurer un niveau d'énergie minimal requis, constant, dans ladite batterie Li-ion, pour une température de référence prédéterminée.

2. Procédé selon la revendication 1, comprenant, préalablement à l'étape a), une étape de génération et de traitement d'un signal d'évaluation de l'état de vieillissement de la batterie.

3. Procédé selon la revendication 1 ou 2, comprenant, après l'étape b), une étape de génération et de traitement d'un signal de fin de charge lorsque la valeur de la tension cellule maximale est supérieure ou égale à la valeur de tension de fin de charge et lorsque la puissance autorisée en charge dans la batterie est inférieure ou égale à la puissance maximale autorisée en fin de charge.

4. Procédé selon la revendication 1 ou 2, comprenant à l'étape b) une étape c) de génération et de traitement d'un signal de modulation de ladite tension de fin de charge augmentée en fonction du déséquilibre cellule.

5. Procédé selon la revendication 4, dans lequel l'étape a) de détermination de la valeur de tension de fin de charge consiste en la détermination de la tension de coupure pour la fin de charge sur la tension cellule maximale et la tension de coupure pour la fin de charge sur la tension cellule minimale en fonction de l'état de vieillissement de la batterie.

6. Procédé selon la revendication 4 ou 5, comprenant, après l'étape c), une étape de réception et de traitement d'un signal de fin de charge lorsque la puissance autorisée en charge dans la batterie est inférieure ou égale à la puissance maximale autorisée en fin de charge et lorsque la valeur de la tension cellule maximale est supérieure ou égale à la tension de coupure pour la fin de charge sur la tension cellule maximale ou lorsque la valeur de la tension cellule minimale est supérieure ou égale à la tension de coupure pour la fin de charge sur la tension cellule minimale.

7. Dispositif de gestion de charge d'une batterie Li-ion en fonction d'au moins un paramètre choisi dans le groupe constitué par le vieillissement de la batterie et le déséquilibre cellule représentant la différence entre l'état de charge de la cellule présentant la charge la plus haute et l'état de charge de la cellule présentant la charge la plus basse, comprenant,

1) des moyens de détermination d'une valeur de tension de fin de charge de ladite batterie,
2) des moyens de traitement agencés pour générer un signal de commande de charge de ladite batterie,
3) des moyens de transmission du signal de commande vers un chargeur,

dans lequel les moyens de traitement sont agencés pour que le signal de commande soit généré de sorte que la charge de la batterie soit effectuée en fonction de la valeur de la tension de fin de charge déterminée, ladite valeur tension de fin de charge étant augmentée en fonction de l'état de vieillissement croissant de ladite batterie Li-ion jusqu'à une valeur limite pour assurer un niveau d'énergie minimal requis, constant, dans ladite batterie Li-ion, pour une température de référence prédéterminée.

8. Dispositif selon la revendication 7, comprenant en outre des moyens de génération et de traitement d'un signal d'évaluation de l'état de vieillissement de la batterie et les moyens de détermination de la valeur de la tension de fin de charge étant agencés pour déterminer la tension de coupure pour la fin de charge sur la tension cellule maximale et la tension de coupure pour la fin de charge sur la tension cellule minimale en fonction de l'état de vieillissement de la batterie.

9. Ensemble de batterie Lithium -ion (11) comportant une batterie Lithium-ion (12) et un dispositif de gestion de charge (13) selon la revendication 7 ou 8.

10. Véhicule automobile incorporant un ensemble de batterie Lithium-ion (11) selon la revendication 9.

**Patentansprüche**

1. Verfahren zur Verwaltung der Aufladung einer Li-Ionen-Batterie in Abhängigkeit von wenigstens einem Parameter, der aus der Gruppe ausgewählt ist, die aus der Alterung der Batterie und dem Zellenungleichgewicht besteht, das die Differenz zwischen dem Ladezustand der Zelle mit der höchsten Ladung und dem Ladezustand der Zelle mit der niedrigsten Ladung darstellt, aufweisend die folgenden Schritte:

   a) Bestimmen eines Ladeschlussspannungswerts der Batterie,
   b) Erzeugen eines Batterieaufladungs-Steuersignals und Übertragen des Steuersignals zu einer Ladevorrichtung, wobei das Steuersignal derart erzeugt wird, dass die Aufladung der Batterie in Abhängigkeit vom Ladeschlussspannungswert erfolgt, der im Schritt a) bestimmt wurde, wobei der Ladeschlussspannungswert in Abhängigkeit vom Zustand der zunehmenden Alterung der Li-Ionen-Batterie bis zu einem Grenzwert erhöht wird, um einen erforderlichen konstanten Mindestenergiepegel in der Li-Ionen-Batterie bei einer vorbestimmten Referenztemperatur sicherzustellen.

2. Verfahren nach Anspruch 1, aufweisend vor dem Schritt a) einen Schritt des Erzeugens und des Verarbeitens eines Signals zur Beurteilung des Alterungszustands der Batterie.

3. Verfahren nach Anspruch 1 oder 2, aufweisend nach dem Schritt b) einen Schritt des Erzeugens und des Verarbeitens eines Ladeschlusssignals, wenn der Wert der maximalen Zellenspannung größer oder gleich dem Ladeschlussspannungswert ist und wenn die zulässige Ladeleistung in der Batterie kleiner oder gleich der zulässigen maximalen Ladeschlussleistung ist.

4. Verfahren nach Anspruch 1 oder 2, aufweisend beim Schritt b) einen Schritt c) des Erzeugens und des Verarbeitens eines Signals zur Modulation der Ladeschlussspannung, die in Abhängigkeit vom Zellenungleichgewicht erhöht wird.

5. Verfahren nach Anspruch 4, wobei der Schritt a) des Bestimmens des Ladeschlussspannungswerts im Bestimmen der Abschaltspannung für den Ladeschluss bei der maximalen Zellenspannung und der Abschaltspannung für den Ladeschluss bei der minimalen Zellenspannung in Abhängigkeit vom Alterungszustand der Batterie besteht.

6. Verfahren nach Anspruch 4 oder 5, aufweisend nach dem Schritt c) einen Schritt des Empfangens und Verarbeitens eines Ladeschlusssignals, wenn die zulässige Ladeleistung in der Batterie kleiner oder gleich der zulässigen maximalen Ladeschlussleistung ist und wenn der Wert der maximalen Zellenspannung größer oder gleich der Abschaltspannung für den Ladeschluss bei der maximalen Zellenspannung ist oder wenn der Wert der minimalen Zellenspannung größer oder gleich der Abschaltspannung für den Ladeschluss bei der minimalen Zellenspannung ist.

7. Vorrichtung zur Verwaltung der Aufladung einer Li-Ionen-Batterie in Abhängigkeit von wenigstens einem Parameter, der aus der Gruppe ausgewählt ist, die aus der Alterung der Batterie und dem Zellenungleichgewicht besteht, das die Differenz zwischen dem Ladezustand der Zelle mit der höchsten Ladung und dem Ladezustand der Zelle mit der niedrigsten Ladung darstellt, aufweisend

   1) Mittel zum Bestimmen eines Ladeschlussspannungswerts der Batterie,
   2) Verarbeitungsmittel, die dafür ausgelegt sind, ein Aufladungs-Steuersignal der Batterie zu erzeugen,
   3) Mittel zum Übertragen des Steuersignals zu einer Ladevorrichtung,

   wobei die Verarbeitungsmittel dafür ausgelegt sind, dass das Steuersignal derart erzeugt wird, dass die Aufladung der Batterie in Abhängigkeit von dem bestimmten Ladeschlussspannungswert erfolgt, wobei der Ladeschlussspannungswert in Abhängigkeit vom Zustand der zunehmenden Alterung der Li-Ionen-Batterie bis zu einem Grenzwert erhöht wird, um einen erforderlichen konstanten Mindestenergiepegel in der Li-Ionen-Batterie bei einer vorbestimmten Referenztemperatur sicherzustellen.

8. Vorrichtung nach Anspruch 7, ferner aufweisend Mittel zum Erzeugen und Verarbeiten eines Signals zur Beurteilung des Alterungszustands der Batterie, wobei die Mittel zum Bestimmen des Ladeschlussspannungswerts dafür ausgelegt sind, die Abschaltspannung für den Ladeschluss bei der maximalen Zellenspannung und die Abschaltspannung für den Ladeschluss bei der minimalen Zellenspannung in Abhängigkeit vom Alterungszustand der Batterie zu bestimmen.

9. Lithium-Ionen-Batterie-Anordnung (11), aufweisend eine Lithium-Ionen-Batterie (12) und eine Vorrichtung zur Verwaltung der Aufladung (13) nach Anspruch 7 oder 8.

10. Kraftfahrzeug, das eine Lithium-Ionen-Batterie-Anordnung (11) nach Anspruch 9 umfasst.

**Claims**

1. Method for managing the charging of a Li-ion battery as a function of at least one parameter chosen from the group comprising the ageing of the battery and the cell unbalance representing the difference between the state of charge of the cell exhibiting the highest charge and the state of charge of the cell exhibiting the lowest charge, comprising the following steps of:

   a) determining an end-of-charge voltage value of said battery,
   b) generating a control signal controlling the charging of said battery and of transmitting the control signal to a charger, the control signal being generated such that the battery is charged as a function of the end-of-charge voltage value determined in step a), said end-of-charge voltage value being increased as a function of the state of ageing of said Li-ion battery until a limit value is reached in order to ensure a constant minimum required energy level in said Li-ion battery, for a predetermined reference temperature.

2. Method according to Claim 1, comprising, prior to step a), a step of generating and processing a signal of evaluation of the state of ageing of the battery.

3. Method according to Claim 1 or 2, comprising, after step b), a step of generating and processing an end-of-charge signal when the maximum cell voltage value is greater than or equal to the end-of-charge voltage value and when the authorized charging power in the battery is less than or equal to the maximum authorized end-of-charge power.

4. Method according to Claim 1 or 2, comprising, in step b), a step c) of generating and processing a modulation signal of said end-of-charge voltage increased as a function of the cell unbalance.

5. Method according to Claim 4, **characterized in that** step a) of determining the end-of-charge voltage value consists of determining the cut-off voltage for the end-of-charge on the maximum cell voltage and the cut-off voltage for the end-of-charge on the minimum cell voltage as a function of the state of ageing of the battery.

6. Method according to Claim 4 or 5, **characterized in that** it comprises, after step c), a step of receiving and processing an end-of-charge signal when the authorized charging power in the battery is less than or equal to the maximum authorized end-of-charge power and when the maximum cell voltage value is greater than or equal to the end-of-charge cut-off voltage on the maximum cell voltage or when the value of the minimum cell voltage is greater than or equal to the end-of-charge cut-off voltage on the minimum cell voltage.

7. Device for managing the charging of a Li-ion battery as a function of at least one parameter chosen from the group consisting of the ageing of the battery and the cell unbalance representing the difference between the state of charge of the cell exhibiting the highest charge and the state of charge of the cell exhibiting the lowest charge, comprising,

   1) means of determining an end-of-charge voltage value of said battery,
   2) processing means arranged to generate a control signal for controlling the charging of said battery,
   3) means of transmitting the control signal to a charger,

   **characterized in that** the processing means are arranged so that the control signal is generated in such a way that the charging of the battery is carried out as a function of the determined end-of-charge voltage value, said end-of-charge voltage value being increased as a function of the increasing state of ageing of said Li-ion battery up to a limit value in order to provide a constant minimum required energy level in said Li-ion battery, for a predetermined reference temperature.

8. Device according to Claim 7, **characterized in that** it furthermore comprises means of generating and processing a signal of evaluation of the state of ageing of the battery and the means of determining the end-of-charge voltage value are arranged to determine the cut-off voltage for the end-of-charge on the maximum cell voltage and the cut-off voltage for the end-of-charge on the minimum cell voltage as a function of the state of ageing of the battery.

9. Lithium-ion battery assembly (11) comprising a lithium-ion battery (12) and a device for managing charging (13) according to Claim 7 or 8.

10. Motor vehicle incorporating a lithium-ion battery assembly (11) according to Claim 9.

## Fig.1

## Fig.2

## Fig.3

**EP 2 957 018 B1**

## RÉFÉRENCES CITÉES DANS LA DESCRIPTION

**Documents brevets cités dans la description**

- WO 2012074406 A2
- US 2009140700 A1
- WO 2007004817 A1